Europäisches Patentamt

European Patent Office

Office européen des brevets

(19)

(11) Publication number: **0 184 941**
**A2**

(12)

# EUROPEAN PATENT APPLICATION

(21) Application number: **85309076.9**

(22) Date of filing: **13.12.85**

(51) Int. Cl.⁴: **G 03 F 7/02, G 03 C 5/00**

(30) Priority: **14.12.84 GB 8431675**

(43) Date of publication of application: **18.06.86**
**Bulletin 86/25**

(84) Designated Contracting States: **AT BE CH DE FR GB IT LI LU NL SE**

(71) Applicant: **Esselte Letraset Limited, St. George's House 195-203 Waterloo Road, London SE1 8XJ (GB)**

(72) Inventor: **Shepherd, John Victor, 48, Knatchbull Way, Brabourne Ashford Kent (GB)**
Inventor: **Thornley, John Stirk, Hunsdon House Kingsnorth Road, Ashford Kent (GB)**

(74) Representative: **Marshall, Monica Anne et al, GALLAFENT & CO. 8 Staple Inn, London WC1V 7QH (GB)**

(54) **Photosensitive materials.**

(57)   Photosensitive materials are described comprising a carrier sheet having thereon a photosensitive layer and comprising a layer which becomes vesicular and remains cohesive under the influence of actinic radiation. When the photosensitive material is imagewise exposed to actinic radiation the photosensitive material becomes preferentially removable from the carrier sheet in the non-exposed or the exposed areas and the vesicle forming layer material becomes vesicular. Thus there is obtained an image which is immediately visible after the imagewise exposure step and accordingly can be used to check that exposure has correctly taken place and which is subsequently developable by removal of the non-exposed or exposed area material.

    The photosensitive material according to this invention is particularly useful in the production of sign making materials and in the production of dry transfer materials using «peel apart» development.

- 1 -

PHOTOSENSITIVE MATERIALS

This invention relates to photosensitive materials and their use.

The reproduction of images using photosensitive materials is of course well known. One area to which attention has recently been directed is the development of photosensitive materials which, after imagewise exposure, can be developed by removal of non-image areas. Thus for example there have been used photosensitive systems comprising a carrier sheet and a water- or solvent-soluble photosensitive layer which become insolubilised (e.g. by photopolymerisation or photocrosslinking) on exposure to light. After imagewise exposure to light therefore the non-exposed areas, which remain water- or solvent-soluble, are washed away to leave only the insolubilised exposed areas. Such systems are described in for example GB 1079661, GB 1364627 and GB 1254475.

There have also been developed photosensitive systems wherein the adhesion of the photosensitive layer to its adjacent carrier increases on exposure to light. Thus, after imagewise exposure, non-image areas are preferentially removed using e.g. a water spray. Such systems are described in for example GB 1581630, GB 1581435 and GB 2009435A.

One particular area to which attention has recently been directed is the development of photosensitive materials which, after imagewise exposure, can be "developed" without the aid of developer liquids. Rather than by chemical means, the images of such materials are developed mechanically. The materials generally comprise two carrier sheets having at least one photosensitive layer therebetween which carrier sheets, after imagewise exposure of the photosensitive layer through one of the carrier sheets, are peeled apart to give the desired image adhered to a carrier sheet. Such "peel apart systems" have been described in for example GB 2029039A, GB 2053497A and EP 0096572.

While these systems offer very convenient ways of reproducing images, they all suffer from the disadvantage that the image is only revealed during the development step when non-image areas are removed. No visible change occurs in the material itself during the imagewise exposure step. The operator is thus not able to perceive the image immediately after imagewise exposure, for example to check that imagewise exposure has been properly carried out. Also, it is not possible to build up images, e.g. legends, using subsequent exposure steps prior to development because any subsequent images cannot be arranged with respect to the former images, which remain invisible until development occurs.

GB 2075701A describes a peel apart system using a laminated product comprising a sensitive layer sandwiched between substrates, the sensitive layer being photopolymerisable and colourless before exposure and comprising a leucocyanide dye. On imagewise exposure, the sensitive layer material becomes photopolymerised and coloured to form a product in which the image and non-image areas can be distinguished and which can be peeled apart to give a final image. However the optical properties of the image obtained in this way are far from satisfactory.

GB 2129952A describes a peel apart system which comprises between two carrier sheets a photopolymerisable layer, which layer contains a light-attenuating, non-photosensitive dye or pigment and contains material which changes colour when exposed to actinic radiation. When this material is imagewise exposed to actinic radiation not only does the material of the photopolymerisable layer polymerise in the exposed areas but also there is a colour change giving an image which can be viewed prior to peeling apart. However the materials of GB 2129952A cannot readily be used when the photopolymerisable material is dark, black (e.g. carbon black) pigmented, as required when the final image is to be a black image of high optical density. If the photopolymerisable material is too dark then the colour change will not be visible against the dark photopolymerisable material.

Vesicular photo-imaging is known. That it is known to produce final images using imaging systems which become vesicular on exposure to light generally with subsequent heating. The light scattering effect of the small bubbles or vesicles formed makes the image areas visible. Such image systems use photosensitive layers comprising a binder and a photosensitive substance capable of releasing nitrogen on exposure to actinic radiation. On imagewise exposure nitrogen is released in the exposed areas and the binder is subsequently softened by the heat resulting in coalescence of the nitrogen gas to form the vesicles in the exposed areas.

It is also known to include in multi-layer photosensitive imaging systems a light-sensitive substance capable of generating gas on exposure to light so that, after imagewise exposure, in the exposed areas the generation of gas causes material to be released from its carrier sheet. Such a material is described in GB 1336065. In addition the use of such light-sensitive gas-generating layers to assist development in a peel apart system is described in GB 1604525, GB 2020836A and GB 2020839A. In all cases the gas-generating layer must be adjacent the carrier sheet from which separation is required. The light-sensitive gas-generating material may be in a separate layer or may be in a layer containing further ingredients. In all cases the gas generation layer is included with a view to detaching from the carrier sheet. Thus the layer must contain sufficient gas-generating substance that, on exposure, to light the layer loses cohesion to ensure release from the carrier sheet in the exposed areas. Because of the gas generation, it is normally the case that a visible image is obtained after exposure (and before development). However this image is not a vesicular image, rather it is formed between the non-exposed attached areas and exposed areas detached due to gas generation.

GB 2023861 describes a peel-apart system for the production of printing plates comprising, between top and base sheets, a photopolymerisable layer and a light-sensitive diazonium layer. In this system the diazonium compound is used such as, on imagewise exposure, to cause selective hardening and increased adhesion whereby the top and base sheets can be peeled apart to provide both negative and positive images on the so separated sheets. This system therefore is concerned with selective hardening and increased adhesion rather than gas formation. Any gas which may be released by the light-sensitive diazonium layer will tend to escape from the system rather than being held.

GB 1354756 describes another use employing imagewise generation of gas. GB 1354756 describes the preparation of a photoresist using an oxygen-sensitive compound, the layer of photoresist being coated with a layer of material which, during exposure to actinic radiation, produces a gas inert to the components of the photoresist. This specification therefore is concerned with the provision of an inert atmosphere for the photoresist layer.

According to the present invention there is provided a photosensitive material which comprises a transparent or translucent carrier sheet and a photosensitive layer, in which, after imagewise exposure of the material to actinic radiation, the non-exposed or the exposed areas are rendered preferentially removable from the carrier sheet, and, in addition, comprising a second layer which becomes vesicular and which remains cohesive on exposure of the photosensitive material to the actinic radiation.

The invention also provides a method of reproducing an image which method comprises imagewise exposing photosensitive material according to the invention and subsequently developing the material to remove photosensitive layer material in the non-exposed or exposed areas.

Thus, according to the invention, there is used material containing a layer, which, on exposure, becomes vesicular while retaining its cohesion. The vesicles obtained in the exposed areas have a light scattering effect and the light scattering image obtained on exposure thus can be viewed prior to development of the imaged photosensitive layer. In particular the vesicular image can be viewed when the photosensitive layer is of high optical density, containing black pigment e.g. carbon black, as is necessary if it is desired that the final image be of high optical density. Indeed the darker the photosensitive layer material, the better the vesicular image formed can be viewed against it.

The pigment or dye may in the usual way be included in the photosensitive layer itself or may be included in a separate layer in the photosensitive material.

The present invention is particularly suitable for use with photosensitive materials which can be developed by mechanical "peel apart" to give the reproduced image. Thus the image is viewable as a vesicular image after the imagewise exposure step and then can be developed by merely peeling apart of the two carrier sheets. Accordingly the present invention provides a photosensitive material which comprises a first carrier sheet and a second carrier sheet and, therebetween, at least a photopolymerisable layer and, in addition, comprising a second layer which becomes vesicular and which remains cohesive on exposure of the photosensitive material to actinic radiation, at least the first carrier sheet being transparent or translucent and the material being such that, on imagewise exposure to actinic radiation, the photopolymerisable layer material becomes polymerised and the said second layer material becomes vesicular in the exposed areas and, after the imagewise exposure and peeling apart of the carrier sheets, the photopolymerisable layer material shears along the edges of the image areas so that in the exposed areas photopolymerisable layer material is retained on the first carrier sheet. The invention further provides a method of reproducing an image which method comprises imagewise exposing such a photosensitive material and peeling apart the two carrier sheets.

The second (vesicle forming) layer according to the present invention is preferably provided on top of the (first) carrier sheet. That is on the outside surface of the photosensitive material on the side from which exposure is carried out. Of course the layer must not prevent actinic radiation reaching the photosensitive layer below.

With the vesicle forming layer according to the invention on top of the (first) carrier sheet in this way, the layer does not interfere with the balance of the adhesions of layers. This is particularly important with "peel apart" systems where adhesion of layers between the carrier sheets and to the carrier sheets themselves of the photosensitive material according to the invention is important to proper working. Moreover when the layer is on top of the (first) carrier sheet in this way it can readily be subsequently removed, if necessary, using a solvent, or by dry stripping. Alternatively the layer can be left in place, optionally after a subsequent uniform exposure step to bleach out any residual colour from the photosensitive material therein.

The vesicle forming layer material can be coated directly on to the carrier sheet or can be part of a separate film e.g. on a separate carrier sheet which is temporarily in contact with the carrier sheet at the time of imaging.

The vesicle forming layer according to the invention may also be included on the underside of the (first) carrier sheet, between layers in the photosensitive material and between carrier sheets as long as its presence does not adversely affect the balance of adhesions and as long as its presence does not adversely affect the final image.

As stated above, the layer which becomes vesicular on exposure to light also retains its cohesion. That is after exposure to light there is no separation from layers or carrier sheet adjacent the layer due to the formation of vesicles in the layer. In some materials however the vesicular layer will remain as part of the final image. In that case the layer must be capable of shearing along the image edges when the material is developed e.g. by peeling apart.

Suitably the vesicle formation is achieved by the generation of gas within the layer to form vesicles. Thus the vesicle forming layer according to the present invention will comprise a binder material and a photosensitive material which is capable of generating gas such that, on imagewise exposure of the photosensitive material, in the exposed areas vesicles of gas are formed in the layer without the cohesion of the layer being lost and, optionally, as mentioned above, dye or pigment.

Suitable photosensitive gas-generating materials are diazo and azido compounds which release nitrogen particularly on exposure to U.V. light. For example fluoroborate salts of diazonium compounds which generate nitrogen on exposure to light may be used.

In addition to the photosensitive gas-generating substance, the vesicle forming layer contains a binder. The binder material must be one which softens sufficiently under the conditions that gas is generated to enable the gas to distort the layer to form the vesicles. Also the binder layer material must be substantially gas impermeable so that the gas-generated upon exposure does not escape. Polyvinylidene chloride is a suitable binder material according to the present invention. There may also be used polyvinyl butyral, polystyrene, polyester, polyvinyl chloride, polyamide, polyvinyl alcohol and polyvinyl acetate and copolymers thereof for example.

The binder layer may also suitably include a humectant e.g. ethylene glycol or triethylene glycol, particularly when the binder is polyvinyl alcohol.

It is important according to the present invention that after exposure the vesicular layer retains its cohesion. This of course contrasts with the formulations of GB 1336065, GB 1604525 and GB 2020836A. Thus the proportions of photosensitive gas-generating material and binder used according to the present invention must be such that on exposure gas generation results in the formation of vesicles with the cohesion of the layer being retained.

Another important factor in the formation of the vesicular layer is the ability of the photosensitive material according to the invention to be heated during the exposure step. This not only increases the softening of the binder but also causes expansion of the gas generated, deforming the binder and possibly coalescing individual gas pockets so that the vesicular effect is readily visible. Generally speaking the darker/blacker the pigment-containing layer of the photosensitive material the greater will be the amount of heating which occurs during the exposure step. Thus not only is this preferred to ensure that the final image is dark if this is required but also enables the image in the vesicular layer according to the present invention to be more readily seen. Most suitably the pigment should be one which not only absorbs IR radiation but also has the ability to absorb shorter wavelengths of light and convert them into heat to heat the entrapped gas and cause it to expand.

Generally speaking the optical density of the pigment-containing layer of the material according to the present invention should be at least 0.5 and preferably more than 1.

The exposure step according to the present invention is preferably carried out using a flash exposure. This is a high energy exposure and this is preferred for the gas-generation according to the present invention. Of course the exposure conditions must not be so severe that the amount of heat generated has an adverse effect on the material itself.

The present invention is particularly useful in the production of signs as described in GB 2053497A. Thus the invention provides a photosensitive material for use in making signs which consists of two carrier sheets, at least one of which is transparent or translucent, the sheets being held together via at least one transparent or translucent layer of adhesive (preferably pressure sensitive adhesive) adjacent the or a transparent or translucent carrier sheet, and photopolymerisable material adjacent the adhesive layer and, in addition, a vesicle forming layer according to the present invention. When this sign making material is imagewise exposed to actinic radiation, the exposed areas are visible as vesicular areas of increased light scattering. Then to develop the image the two carrier sheets are peeled apart and the photopolymerisable layer, the exposed parts of which will have been photopolymerised under the influence of the imagewise exposure will shear along the edges of the image areas so that there is obtained the transparent or translucent carrier sheet having on its adhesive bearing side indicia formed by the photopolymerised material. This may then be used as a sign, the adhesive serving to adhere the whole to a receptor surface to give a sign in which the indicia are protected for example against abrasion by means of the overlying transparent or translucent carrier sheet.

The invention is also particularly useful in the production of dry transfers as described in GB 2029039A. Thus, according to preferred embodiment, the invention also provides a photosensitive material for use in the production of dry transfer materials comprising, in order, a first carrier sheet, a photopolymerisable layer, a shearable layer containing dye or pigment and a second carrier sheet and, in addition, a vesicle forming layer according to the present invention; wherein, prior to exposure, on peeling apart of the sheets, the photopolymerisable and shearable pigmented or dyed layers are both retained wholly on the second carrier sheet, and wherein, after exposure, the photopolymerisable layer and at least part of the shearable layer are retained on the first carrier sheet.

Thus again after imagewise exposure of the photosensitive material the image is visible as vesicular areas of increased light scattering from the remainder of the material.

The invention is also useful in the production of dry transfers by the method described in EP 0096572. Thus the vesicle forming layer according to the present invention

can be included in a photosensitive material for use in the making of dry transfer material comprising in order a first transparent or translucent, flexible carrier sheet, a first photopolymerisable layer, shearable image-forming layer, an adhesive layer which is a permanently tacky pressure-sensitive adhesive composition or which is capable of becoming a permanently tacky pressure-sensitive adhesive composition on exposure to light, and, adjacent the adhesive carrier layer, a second flexible carrier sheet, which second carrier sheet is transparent or translucent at least when the adhesive layer is photosensitive, the ease with which the first photopolymerisable layer may be removed from the first carrier sheet being increased under the action of actinic radiation.

The material of the present invention is particularly useful for the building up of images by subsequent exposure steps whereby the visible image obtained can be used for visual spacing for a subsequent exposure step before peel apart. There is used a negative in which the non-image areas are generally opaque to actinic radiation (e.g. U.V. light) but transparent to part of the visible spectrum while the image areas are transparent to visible and non-visible light and appropriately sensitive material according to the present invention. Such a negative will enable the vesicular image formed on exposure to be seen through the non-image areas while the transparent image itself on the negative will be clearly visible against the coloured non-image areas of the negative. Thus the negative can be aligned by eye against the vesicular image. A suitable non-image area colour for the negative is e.g. orange which absorbs U.V., blue and some of the green portion of the spectrum, but transmits the remaining green and red.

This method is for example suitable for the building up of words. Thus the material according to the invention can be imagewise exposed to a negative of a letter. Then the visible vesicular image of this letter is used visually to position the negative of the next letter. There is a second imagewise exposure step so that an appropriately positioned image of that letter is formed in the photosensitive material. This can be continued until the whole word, text etc. has been built up prior to the material being developed.

The invention is further illustrated in the following Examples.

### EXAMPLE 1

There was prepared a sign-making material in accordance with GB 2053497A as follows:

An adhesion control composition was prepared containing the following ingredients:

|                                                                          | Parts by weight |
| ------------------------------------------------------------------------ | --------------- |
| Poly(vinylidene chloride) copolymer resin (SARAN F ex Dow Chemicals)     | 5               |
| Polyester solution resin (Vitel PE200 ex Goodyear Chemicals)             | 5               |
| Butan-2-one                                                              | 90              |

A solution of each resin (10% non volatiles) was prepared by dissolving chips or powder of the resin in the but-2-one solvent. The solutions were mixed in equal amounts and stirred until homogeneous to give the above composition. The composition obtained was coated onto polyethylene terephthalate extruded film (75 micron caliper, Melinex 542 ex I.C.I.) (substrate 1) using a 0.02 cm wire wound coating bar. The layer was dried in a fan assisted oven at 50°C.

There was prepared a first adhesive composition as

follows:

|  | Parts by weight |
|---|---|
| Polyisobutene (Oppanol B50 ex BASF) | 40 |
| Polybutene (Hyvis 200 ex B.P. Chemicals) | 300 |
| Hydrogenated rosin ester (Stabelite Ester 10 ex Hercules) | 80 |
| Silica (Aerosil 300 ex Degussa) | 140 |
| Electro neutral salt of polycarbonic acid with amine derivatives dissolved, approximately 50% non volatiles, in higher aromatic solvent (Product 963 ex Henkel Chemicals) | 2 |
| 2-ethoxyethanol | 40 |
| Aliphatic hydrocarbon solvent (Exsol D145/160 ex Esso) | 4120 |
| Silicone pressure-sensitive adhesive, 60% non volatiles in xylene (DC282 ex Dow Corning) | 236 |

All the ingredients, except the silicone pressure-sensitive adhesive, were dispersed using a high shear stirrer in half the amount of aliphatic hydrocarbon solvent given above. After the dispersion had reached

- 14 -

homogeneity, the remainder of the aliphatic hydrocarbon solvent was added and stirring was continued until the mixture was again homogeneous. The silicone pressure-sensitive adhesive was mixed in immediately prior to use using a paddle stirrer.

The adhesive composition thus obtained was coated on top of the adhesion control layer using a 0.05 cm wire wound coating bar and the layer was dried in a fan assisted oven at 50°C.

An image-forming layer was prepared as follows: There was first prepared a pigment premix of the following composition:

|  | Parts by weight |
| --- | --- |
| Polyvinyl alcohol (Gelvatol 40-20 ex Monsanto) | 60 |
| Carbon black (Printex 2/0 ex Degussa) | 400 |
| De-ionised water | 540 |

The polyvinyl alcohol was dissolved in the water using a paddle stirrer. The pigment was then mixed in and ball milled until the pigment dispersion had a Hegman grind of 7.0 or better.

A hydroxyethyl cellulose solution was prepared of the following composition:

|  | Parts by weight |
| --- | --- |
| Hydroxyethyl cellulose (Natrosol 250 HHR ex Hercules) | 20 |
| Biocide (Glokill 80 ex A.B.M.) | 1 |
| De-ionised water | 979 |

The hydroxyethyl cellulose powder was added to a mixture of the water and biocide and the composition stirred until the powder dissolved and the mixture thickened.

The image forming layer composition was prepared as follows:

|  | Parts by weight |
|---|---|
| Pigment pre-mix | 200 |
| Hydroxyethyl cellulose solution | 200 |
| Sodium di-octyl sulphosuccinate, 60% in isopropanol (Anonaid TH ex A.B.M. Chemicals) | 16 |
| De-ionised water | 500 |

The ingredients were mixed and the composition stirred until homogeneous.

The image-forming layer composition was coated on top of the first adhesive coating using a 0.04 cm wire wound coating bar and was dried in a fan assisted oven at 50°C.

A photopolymer composition was prepared as follows:

|  | Parts by weight |
|---|---|
| Tri-functional acrylic ester monomer (Photomer 4094 ex Lankro Chemicals) | 30 |
| Isopropyl thioxanthone (Quantacure ITX ex Ward Blenkinsop) | 0.75 |
| 2-N-butoxyethyl-4-(dimethyl-amino)-benzoate (Quantacure BEA ex Ward Blenkinsop) | 1.75 |

|  | Parts by weight |
|---|---|
| Ethoxylated nonyl phenol surfactant (Synperonic NP8 ex I.C.I./Cargo Fleet Chemicals) | 3.3 |

The ingredients were mixed together and stirred with a paddle stirrer until the isopropyl thioxanthone dissolved and stirring was continued.

There were mixed together:

|  | Parts by weight |
|---|---|
| Acrylic polymer emulsion, 50% non volatiles (National EP4711 ex National Adhesives and Resins) | 30 |
| De-ionised water | 15 |

This mixture was slowly added to the stirred acrylic ester monomer-containing composition and stirring was continued until the dispersion thickened slightly.

The photopolymer composition so obtained was coated over the image-forming layer using a 0.04 cm wire wound coating bar and dried in a fan assisted over at 50°C.

There was prepared a second adhesive composition comprising:

|  | Parts by weight |
|---|---|
| Silicone pressure-sensitive adhesive, 60% non volatiles in xylene (DC282) | 50 |
| Xylene | 50 |

These ingredients were stirred until homogeneous and the second adhesive composition thus obtained was coated onto a second polyethylene terephthalate extruded film substrate (Melinex 542, 36 microns - substrate 2) using a 0.05 cm wire wound coating bar. The layer thus obtained was dried in a fan assisted oven at 50°C.

Using a heated lamination press with the temperature set to approximately 70°C, the adhesive coated side of this second substrate sheet was laminated to the photopolymer coated side of the first substrate sheet.

To the second polyethylene terephthalate sheet (having the second adhesive layer adjacent it) of the laminate so obtained, there was applied, using a 0.03 cm wire wound coating bar, a solution of the following composition:

|  | Parts by weight |
|---|---|
| Polyvinylidene chloride copolymer (SARAN F (ex du Pont)) | 1 |
| 4-N,N-Diethylaminobenzene diazonium chloride ½ zinc chloride salt (Fi-Line sensitiser DE ex ABM Chemicals) | 0.3 |
| Butan-2-one | 18 |

The mixture was stirred until the powders dissolved. The coating was dried in a fan assisted oven at 50°C.

Using a Color Key transparent orange negative master, adjacent to the coating on the second polyethylene terephthalate sheet, and a xenon flash unit (Projectaline Inc., tube rated at 60W) the laminate was imagewise exposed with 10 flashes per required image. An opalescent image was visible immediately in each exposure area. These images could be viewed through the negative master to allow alignment of subsequent images.

On completion of the require imaging processes, the two polyethylene terephthalate sheets were peeled apart revealing the desired positive black image on the second substrate corresponding to the vesicular images previously seen. This substrate could then be used as a self-adhesive label.

The coating layer could be removed or its yellow colour bleached by overall exposure to U.V. radiation of low intensity.

## EXAMPLE 2

There was prepared a laminate material by the method described in Example 1.

To the second polyethylene terephthalate sheet (having the second adhesive layer adjacent it) of the laminate, there was applied, using a 0.02 cm wire wound Meyer bar, a solution of the following composition:

|  | Parts by weight |
|---|---|
| Polyvinylidene chloride copolymer (SARAN F) | 2 |
| 3-Methoxy-4-pyrolidinobenzene diazonium fluoroborate (Fi-Line sensitiser MBP.BF4 ex ABM Chemicals) | 0.3 |
| Butan-2-one | 18 |

The coating was dried.

A negative was placed over the coated laminate. A xenon flash unit as used in Example 1 was placed against the negative and eight flashes were made. A vesicular image was formed in the coated layer which again remained cohesive.

## EXAMPLE 3

Light sensitive material was prepared and exposed as in Example 2 except that this time there was used a coating composition as follows:

|  | Parts by weight |
|---|---|
| Polystyrene (Moulding grade GP91UL ex BP Chemicals) | 2 |
| Diazo compound as in Example 2 | 0.3 |

|  | Parts by weight |
| --- | --- |
| Butan-2-one | 18 |

Similar results were obtained.

### EXAMPLE 4

Light sensitive material was prepared and exposed as in Example 2 except that this time there was used a coating compositions as follows:

|  | Parts by weight |
| --- | --- |
| Polyester solution resin (Vitel PE200) | 2 |
| Diazo compound as in Example 2 | 0.3 |
| Butan-2-one | 17 |
| Toluene | 1 |

Similar results were obtained.

### EXAMPLE 5

There was prepared a laminate material by the method described in Example 1.

To the second polyethylene terephthalate sheet (having the second adhesive layer adjacent it) of the laminate, there was applied, using a 0.03 cm wire wound Meyer bar, a solution of the following composition:

|  | Parts by weight |
| --- | --- |
| Polyamide (Elvamide 8061 ex DuPont) | 1 |
| Diazo compound as in Example 2 | 0.2 |
| Methanol | 19 |

The coating was dried.

A negative was placed over the coated laminate. A xenon flash unit as used in Example 1 was placed against the negative and eight flashes were made. A vesicular image was formed in the coated layer which remained cohesive.

EXAMPLE 6

Light sensitive material was prepared and exposed as in Example 5 except that this time there was used a coating composition as follows:

|  | Parts by weight |
|---|---|
| Polyvinyl chloride (Corvic P55/60 ex I.C.I.) | 1 |
| Diazo compound as in Example 2 | 0.2 |
| Butan-2-one | 19 |

Similar results were obtained.

EXAMPLE 7

There was prepared a laminate by the method described in Example 1.

To the second polyethylene terephthalate sheet (having the second adhesive layer adjacent it) of the laminate, there was applied, using a 0.02 cm wire wound Meyer bar, a water based coating of the following composition:

|  | Parts by weight |
|---|---|
| Polyvinylidene chloride emulsion (50% solids aqueous emulsion, Polidene 33-041 ex Scott Bader Company) | 20 |
| Sodium di-octyl sulphosuccinate, 60% solids solution in isopropanol (Anonaid TH) | 1 |

<div align="right">Parts by weight</div>

4-N,N-dimethylaminobenzene
diazonium chloride ½ zinc
chloride salt (Fi-Line
sensitiser DM ex ABM Chemicals)          1

This coating was dried at 50°C for 5 minutes in a fan assisted oven.

A negative was placed over the coated laminate. A flash exposure was carried out as in Example 1 with four flashes being made. A vesicular image was formed in the coated layer which remained cohesive.

## EXAMPLE 8

A polyethylene terephthalate extruded film substrate (Melinex 542, 75 micron caliper) was provided with an adhesion control layer, a first adhesive layer, an image-forming layer and a photopolymer layer as described in Example 1.

A second polyethylene terephthalate extruded film substrate (Melinex 542, 36 micron) as used in Example 1 was provided with a vesicle forming layer of the following composition:

<div align="right">Parts by weight</div>

| | |
|---|---|
| Polyvinylidene chloride copolymer (SARAN F) | 2 |
| Diazo compound as used in Example 2 | 0.3 |
| Butan-2-one | 18 |

The resin and diazo compound were dissolved in the butan-2-one solvent using a paddle stirrer. This composition was coated on to the second polyethylene terephthalate film substrate using a 0.05 cm wire wound coating bar and dried in a fan assisted oven at 50°C.

A second adhesive composition, as used in Example 1, was coated on top of this vesicle-forming coating using a 0.05 cm wire wound coating bar and was dried in a fan assisted oven at 50°C.

Using a heated lamination press with the temperature set to approximately 70°C, the coated side of this second substrate was laminated to the photopolymer coated side of the first substrate as described in Example 1.

The laminate material so obtained was exposed in the manner described in Example 1 though using 10 flashes per image. There was obtained an opalescent image which was visible on exposure. A black positive image was obtained on the second substrate when the two substrates were peeled apart.

### EXAMPLE 9

A pigment dispersion was prepared as follows:

300g pigment (Monastral Blue BG, ex I.C.I.) were dispersed in 700g polyvinyl alcohol solution (10% solids in water, Gelvatol 40-20, ex Monsanto) using a ball mill and tumbling for 48 hours.

A silica dispersion was prepared as follows:

250g silica (Neosyl, ex Crossfield Chemicals) were dispersed in 750g polyvinyl alcohol solution (as for pigment) using a ball mill and tumbling for 24 hours.

The following materials were mixed together to give an emulsion:

|  | Parts by weight |
|---|---|
| 10% Polyvinyl alcohol solution in water (Gohsenol GL-03 ex Nippon Gohsei) | 120 |
| Pigment dispersion | 40 |
| Acrylate monomer (AM 548 ex Synthese BV) | 20 |

|  | Parts by weight |
|---|---|
| Free radical initiator (30% Quantacure ITX in Quantacure BEA ex Ward Blenkinsop Ltd) | 4 |
| Surfactant (Tween 80 and Span 80 ex Honeywell Atlas mixed in proportions to give an HLB value of 11) | 27.6 |
| Silica dispersion | 55.2 |
| Polyvinyl acetate dispersion (Emultex 592 ex Harlow Chemical Company Ltd.) | 55.2 |

This emulsion was coated on to polyethylene terephthalate (542 Melinex ex I.C.I. Ltd.) using a No. 15 Meyer bar.

The following materials were mixed together to give a diazo solution:

|  | Parts by weight |
|---|---|
| 2,5-Diethoxy-4-morpholino-benzene diazonium fluoroborate (Fi-Line sensitiser DEM.BF4 ex ABM Chemicals) | 0.6 |
| Polyvinylidene chloride (SARAN F) | 4 |
| Butan-2-one | 16 |

This solution was coated on to the opposite side of the Melinex from the emulsion coating using a No. 3 Meyer bar.

The material was exposed via a transparent orange negative (made with Color-Key from 3M) using a xenon flash unit as used in Example 1. The diazo coated side of the sheet was adjacent to the negative. With an exposure of eight flashes an immediate opalescent image was generated in the diazo layer which was visible through the orange background of the Color-Key negative. This allowed the negative to be repositioned for subsequent exposures. On completion of the required exposures the emulsion coating was developed using a water spray. A series of blue images corresponding to the opalescent images already generated in the diazo layer were revealed.

EXAMPLE 10

A silicone release coating was prepared according to the following formulation:

|  | Parts by weight |
|---|---|
| Silicone polymer containing catalyst (Syl-off 7046 ex Dow Corning) | 20.5 |
| Crosslinking agent (Syl-off 7048 ex Dow Corning) | 0.102 |
| Adhesion modifier (Syl-off Q2-7089 ex Dow Corning) | 0.92 |
| Exsol 145/160 (a hydrocarbon solvent ex Esso) | 14.24 |
| Butan-2-one | 14.24 |

This formulation was coated on to polyethylene terephthalate using a No. 72 Meyer bar, and cured at 120° for 5 minutes.

The folloing materials were mixed together to form an emulsion:

|  | Parts by weight |
|---|---|
| 10% Polyvinyl alcohol solution in water (Gohensol GL-03) | 120 |

|  | Parts by weight |
|---|---|
| Pigment dispersion as in Example 9 | 40 |
| Acrylate monomer (AM 549) | 20 |
| Free radical initiator as in Example 9 | 4 |
| Surfactant as in Example 9 | 27.6 |
| Silica dispersion as in Example 9 | 55.2 |

This emulsion was coated on to the cured silicone coating using a No. 15 Meyer bar.

The diazo solution from the Example 9 was coated on to the opposite side of the polyethylene terephthalate to the silicone/emulsion coating. A negative made from transparent orange Color-Key was placed emulsion side down on the diazo coating and the material was exposed using a xenon flash unit as used in Example 1.

A vesicular image was formed on the substrate during the flash exposure. Sixteen flashes per image were required to obtain satisfactory imaging of the emulsion coating during the subsequent development stage. The exposed material was soaked in a water bath at ca.20°C for 1 minute and any remaining unexposed material was gently removed with a flow of water at a similar temperature. The resulting blue image corresponded to the vesicular image. These images could be transferred by rubbing over the substrate supported by the final artwork.

## EXAMPLE 11

A laminate was prepared by the method of Example 1 except that a solution was prepared from the following ingredients:

|  | Parts by weight |
|---|---|
| 10% solution of polyvinyl alcohol in water (Moviol 40-88 ex Harlow Chemicals) | 96.5 |
| Triethylene glycol | 2.4 |
| 4-N,N-dimethylaminobenzene diazonium chloride zinc salt (Fi-Line sensitiser DM2 ex ABM Chemicals) | 1.1 |

It was this solution which was applied to the second polyethylene terephthalate sheet rather than that given in Example 1 and dried.

The laminate obtained was imagewise exposed as in Example 1. There was obtained a visible vesicular image allowing the image to be viewed. The imaged material could be peeled apart to give image areas on an adhesive substrate as in Example 1.

The image material thus obtained was adhered to a receptor surface and the vesicular layer could be stripped off as a dry film by attaching pressure-sensitive adhesive tape to the top of the coating layer and then peeling off tape taking with it the vesicular coating layer. The black image areas could then be viewed in full contrast.

CLAIMS

1. A photosensitive material which comprises a transparent or translucent carrier sheet and a photosensitive layer, in which, after imagewise exposure of the material to actinic radiation, the non-exposed or the exposed areas are rendered preferentially removable from the carrier sheet, and characterised in that, in addition, it comprises a second layer which becomes vesicular and which remains cohesive on exposure of the photosensitive material to the actinic radiation.

2. A photosensitive material according to claim 1 characterised in that the said second layer is on the other side of the carrier sheet from the photosensitive layer.

3. A photosensitive material according to claim 1 which comprises a first carrier sheet and a second carrier sheet and, therebetween, a photopolymerisable layer, at least the first carrier sheet being transparent or translucent and the material being such that, on imagewise exposure of the photosensitive material to actinic radiation, the photopolymerisable layer material becomes polymerised in the exposed areas and, after the imagewise exposure and peeling apart of the carrier sheets, the photopolymerisable layer material shears along the edges of the image areas so that in the exposed areas photopolymerisable layer material is retained on the first carrier sheet, characterised in that, in addition, the photosensitive material comprises a second layer which becomes vesicular and remains cohesive on exposure to actinic radiation such that, on the imagewise exposure of the photosensitive material to actinic radiation, the said second layer material becomes vesicular in the exposed areas.

4.   A photosensitive material according to claim 3 characterised in that the said second layer is provided on top of the first carrier sheet.

5.   A photosensitive material according to claim 3 characterised in that the said second layer is provided under the first carrier sheet.

6.   A photosensitive material according to any one of the preceding claims characterised in that the said second layer comprises a binder and a photosensitive material capable of generating gas such that, on imagewise exposure of the photosensitive material, in the exposed areas vesicles of gas are formed in the layer material without the cohesion of the layer being lost.

7.   A method of reproducing an image characterised in that it comprises imagewise exposing a photosensitive material as claimed in any one of claims 1 to 6 and developing the image to remove photosensitive layer material in the non-exposed or exposed areas.

8.   A method according to claim 7 characterised in that a flash exposure is used.

9.   A method according to claim 7 or 8 characterised in that the photosensitive material is exposed through a first negative comprising a non-image area opaque to substantially all actinic radiation but transparent over part of the visible spectrum of light and an image area transparent to actinic radiation, a second negative is visually aligned with respect to the vesicular image obtained, the photosensitive material is exposed through the second negative and subsequently the material is developed.

10. A method according to any one of claims 7 to 9 characterised in that there is used a photosensitive material as claimed in any one of claims 3 to 5 wherein the material is developed by peeling apart the two carrier sheets.